Europäisches Patentamt

European Patent Office

Office européen des brevets

(11) Veröffentlichungsnummer: **0 174 588 B1**

# (12) EUROPÄISCHE PATENTSCHRIFT

(45) Veröffentlichungstag der Patentschrift: **20.03.91**

(51) Int. Cl.⁵: **G03F 7/095**

(21) Anmeldenummer: **85111092.4**

(22) Anmeldetag: **03.09.85**

(54) **Strahlungsempfindliches Aufzeichnungsmaterial und Verfahren zu seiner Herstellung.**

(30) Priorität: **11.09.84 DE 3433247**

(43) Veröffentlichungstag der Anmeldung:
**19.03.86 Patentblatt 86/12**

(45) Bekanntmachung des Hinweises auf die
Patenterteilung:
**20.03.91 Patentblatt 91/12**

(84) Benannte Vertragsstaaten:
**CH DE FR GB IT LI NL**

(56) Entgegenhaltungen:
FR-A- 721 280
FR-A- 2 521 314
GB-A- 2 080 965

PATENT ABSTRACTS OF JAPAN, Band 7, Nr.
82 (P-189)[1227] 6. April 1983; & JP-A-58 11
943 (RICOH K.K.) 22-01-1983

PATENT ABSTRACTS OF JAPAN, Band 3, Nr.
85 (E-124), 21. Juli 1979; & JP-A-54 61 931
(SUWA SEIKOSHA K.K.) 18-05-1979

PATENT ABSTRACTS OF JAPAN, Band 6, Nr.
168 (P-139)[1046], 2. September 1982; & JP-
A-57 85 048 (DAICEL K.K.) 27-05-1982

(73) Patentinhaber: **HOECHST AKTIENGESELL-
SCHAFT**
**Postfach 80 03 20**
**W-6230 Frankfurt am Main 80(DE)**

(72) Erfinder: **Seibel, Markus, Dr., Dipl.-Chem.**
**Am Rosengarten 16**
**W-6500 Mainz(DE)**
Erfinder: **Kämpf, Günther, Dr. Dipl.-Phys.**
**Rebhangstrasse 3**
**W-6227 Oestrich-Winkel 3(DE)**

## Beschreibung

Die Erfindung betrifft ein strahlungsempfindliches Aufzeichnungsmaterial mit rauher Oberfläche, das insbesondere zur Herstellung von Flachdruckplatten geeignet ist, sowie ein Verfahren zu seiner Herstellung, bei dem eine rauhe Deckschicht durch Aufsprühen einer Lösung hergestellt wird.

Es ist bekannt, lichtempfindliche Flachdruckplatten mit einer rauhen Deckschicht zu versehen, um die Evakuierung des Kopierrahmens bei der Belichtung im Vakuumkontaktverfahren zu beschleunigen. Bei Druckplatten mit glatter Oberfläche kann es beim Evakuieren des Zwischenraums zwischen lichtempfindlicher Schicht und Filmvorlage zu einer unvollständigen Absaugung kommen, weil die Luft aus dem Mittelteil, insbesondere von großformatigen Platten, nur schwierig zu entfernen ist. Die Lufteinschlüsse führen dann in der Kopie zu Unterstrahlungseffekten, wobei insbesondere feine Rasterpunkte an diesen Stellen ungenau, unvollständig oder auch gar nicht wiedergegeben werden. Diese Nachteile lassen sich durch Verwendung von Druckplatten, deren lichtempfindliche Schicht eine rauhe Oberfläche hat, weitgehend vermeiden.

Man hat rauhe Oberflächen z. B. durch Aufbringen einer Deckschicht erzeugt, die Pigmentpartikel enthält (DE-A 25 12 043) oder man hat die Oberfläche der lichtempfindlichen Schicht oder einer zusätzlichen Deckschicht durch Verwendung einer Beschichtungswalze mit unebener Oberfläche gerauht (DE-A 25 33 156). Es ist auch bekannt, Pigmentpartikel in die lichtempfindliche Schicht selbst einzubringen, die dicker als die Schicht sind (DE-A 29 26 236), oder ein Feststoffpulver gleichmäßig auf die Schichtoberfläche aufzustäuben und dort durch Erwärmen zu verankern (DE-A 30 03 131).

Alle Verfahren, die unlösliche oder schwerlösliche Pigmente, z. B. Kieselsäure, verwenden, haben den Nachteil, daß sich diese später als Bodensatz im Entwickler ansammeln und dort gegebenenfalls Sprühdüsen verstopfen oder andere Störungen verursachen.

Es ist weiterhin bekannt, auf die lichtempfindliche Schicht eine rauhe Deckschicht aufzubringen, die im Entwickler vollständig löslich ist (DE-A 26 06 793). Gemäß der DE-A 31 31 570 wird die Deckschicht durch Sprühbeschichten aus wäßriger Lösung oder Dispersion aufgebracht. Die Deckschicht besteht aus einem Harz, das entweder bereits in Wasser oder zumindest in der verwendeten Entwicklerlösung löslich ist.

Ein ähnliches Verfahren ist in der DE-A 33 04 648 beschrieben. Danach wird ein Harz in wäßriger Lösung oder Dispersion durch elektrostatisches Versprühen aufgebracht.

Die nach diesen Verfahren erhaltenen Deckschichten haben den Nachteil, daß sie bzw. ihre Partikel nur relativ locker auf der lichtempfindlichen Schicht haften. Bei der Verwendung von Wasser als Lösemittel oder Dispergiermedium wird nämlich die regelmäßig wasserunlösliche lichtempfindliche Schicht nicht angelöst, so daß beim Trocknen keine feste Verankerung erfolgen kann. Wird eine Dispersion zur Beschichtung verwendet, so liegen die dispergierten Teilchen nach dem Trocknen in ihrer ursprünglichen Form auf der Schichtoberfläche, ohne darin eingebettet zu werden. Wenn eine wäßrige Lösung verwendet wird, entstehen zwar beim Trocknen dieser Lösung Partikel, die sich der Schichtoberfläche an ihrer Berührungsstelle anpassen und deshalb etwas besser haften; sie können jedoch ebenfalls nicht eingebettet werden, da die Schichtoberfläche von der Sprühlösung nicht angegriffen wird. Ein weiterer Nachteil der wasserlöslichen Harze besteht darin, daß diese bei der Belichtung mit den Lichtzersetzungsprodukten oder bei der meist alkalischen Entwicklung mit in der Schicht vorhandenen Diazoverbindungen unter Ausbildung einer dünnen hydrophilen Schicht auf der Oberfläche reagieren können, die beim Entwickeln nicht oder nicht vollständig entfernt wird. Die Folge ist dann eine ungenügende Farbannahme in den Bildstellen der Druckplatte, zumindest zu Beginn des Druckvorgangs, die zu einer erheblichen Anzahl an Fehldrucken führt.

Außerdem haben alle entwicklerlöslichen Deckschichten den Nachteil, daß sie den Entwickler vorzeitig erschöpfen, da ihre Bestandteile bei der Entwicklung vollständig gelöst werden.

Aufgabe der Erfindung war es, ein strahlungsempfindliches Aufzeichnungsmaterial, vor allem für die Herstellung von Druckplatten, insbesondere Flachdruckplatten, bereitzustellen, das die oben genannten Vorteile der bekannten Materialien mit rauher Oberfläche beim Kopieren aufweist, das aber einfacher herzustellen ist, durch das der Entwickler nicht schneller verbraucht und nicht stärker verunreinigt wird als durch ein übliches Material ohne rauhe Deckschicht und das eine rauhe Deckschicht aufweist, die auf der Oberfläche der lichtempfindlichen Schicht besser haftet als bekannte Deckschichten gleicher Art.

Die Erfindung geht aus von einem strahlungsempfindlichen Aufzeichnungsmaterial mit einem Schichtträger, einer strahlungsempfindlichen Aufzeichnungsschicht und einer durch Versprühen und Trocknen einer Lösung aufgebrachten rauhen Deckschicht.

Das erfindungsgemäße Aufzeichnungsmaterial ist dadurch gekennzeichnet, daß die Deckschicht im wesentlichen die gleiche Zusammensetzung hat wie die Aufzeichnungsschicht. Die Deckschicht wird vorzugsweise aus einer Lösung in organischem Lösemittel aufgebracht.

Erfindungsgemäß wird ferner ein Verfahren zur Herstellung eines strahlungsempfindlichen Aufzeichnungsmaterials mit rauher Oberfläche vorgeschlagen, bei dem auf eine auf einem Schichtträger befindliche glatte strahlungsempfindliche Aufzeichnungsschicht eine Lösung so aufgesprüht wird, daß auf der glatten Oberfläche diskrete Flüssigkeitströpfchen gebildet werden, von denen mindestens ein Teil zu diskreten Partikeln getrocknet wird.

Das erfindungsgemäße Verfahren ist dadurch gekennzeichnet, daß man eine Lösung aufsprüht, die im wesentlichen die gleichen Bestandteile wie die Aufzeichnungsschicht gelöst enthält.

Bei dem erfindungsgemäßen Sprühbeschichtungsverfahren wird die Oberfläche der zu beschichtenden licht- bzw. strahlungsempfindlichen Schicht von den Tröpfchen der Sprühlösung gut benetzt, da das Lösemittel bzw. das Lösemittelgemisch auch die lichtempfindliche Schicht löst. Auf diese Weise wird die Substanz jedes Tröpfchens gut mit der örtlich angelösten lichtempfindlichen Schicht vereinigt und fest darin verankert. Da die Schicht nur an den Stellen angelöst wird, an denen zusätzliche Substanz abgelagert wird, bleibt im wesentlichen die ursprüngliche lichtempfindliche Schicht als Grundschicht erhalten; es treten keine lokalen Verminderungen der Schichtdicke auf. Bei der Belichtung und Entwicklung werden nur die Schichtbereiche entfernt, die den Nichtbildstellen entsprechen, während an den Bildstellen auch die aufgesprühten Schichtpartikel zurückbleiben.

Die Bestandteile der Sprühlösung werden im allgemeinen in einem organischen Lösemittel oder einem Gemisch aus organischen Lösemitteln gelöst und durch Sprühantrag auf die bereits vorhandene lichtempfindliche Schicht aufgebracht. Die Konzentration der Sprühlösung und die Zusammensetzung des Lösemittels müssen so eingestellt sein, daß eine ausreichende Haftung der aufgesprühten Partikel auf der darunterliegenden lichtempfindlichen Schicht gewährleistet ist und daß die auf der Platte auftreffenden Tröpfchen in bestimmtem Maße verlaufen und so zu einer Oberfläche mit der gewünschten Rauhigkeit führen. Neben dem üblichen Sprühverfahren mittels Druckluft hat sich insbesondere das elektrostatische Sprühen bewährt. Beispiele solcher Verfahren umfassen das elektrostatische Luft-Sprühverfahren, das elektrostatische luftfreie Sprühverfahren sowie das elektrostatische Rotations-Sprühverfahren. Die zur Durchführung dieser Verfahren verwendeten Vorrichtungen sind bekannt. Bei jedem dieser Verfahren werden kleine Flüssigkeitströpfchen gebildet, elektrostatisch aufgeladen und dann einem starken elektrischen Feld ausgesetzt, das zwischen der Elektrode, aus der die Flüssigkeitströpfchen austreten, und dem Träger mit der lichtempfindlichen Schicht, auf der die rauhe Oberfläche gebildet werden soll, anliegt. In der Regel wird der Träger geerdet, um den Sicherheitsvorschriften zu genügen. Die Polarität der angelegten Spannung hängt von der Bauart der verwendeten Anlage ab und hat keinen erkennbaren Einfluß auf die Qualität der erzeugten Oberfläche. Im allgemeinen wird eine Hochspannung im Bereich von 50 bis 120 kV angewendet.

Beim Aufbringen von rauhen Deckschichten hat sich insbesondere der elektrostatische Sprühantrag vom Rotations-Sprühtyp, gegebenenfalls mit Druckluftunterstützung, bewährt. Die Größe der getrockneten Partikel liegt zwischen etwa 0,1 und 10 μm, und diese können eine sehr unregelmäßige Gestalt haben und gegebenenfalls vor dem Erstarren untereinander zu ausgedehnteren Gebilden verlaufen. Mit dieser Anordnung können rauhe bzw. unebene Deckschichten erzeugt werden, deren Antrag einfach zu bewältigen ist und die nicht von der Schichtdicke der darunterliegenden lichtempfindlichen Schicht abhängen. Dadurch, daß die aufgebrachte Deckschicht aus dem gleichen Material wie die darunterliegende lichtempfindliche Schicht besteht, ist eine gute Haftung leicht zu bewerkstelligen, und es müssen keine Oberflächenspannungsunterschiede oder unterschiedliche Ausdehnungskoeffizienten bei Temperaturänderungen oder dergleichen beachtet werden.

Der besondere Vorteil gegenüber dem Stand der Technik ist darin zu sehen, daß die rauhe Deckschicht selbst noch eine Differenzierung beim Belichten erfährt und so eine Unterstrahlung zusätzlich verhindert. Außerdem sind alle Schichtbestandteile im Entwickler gut löslich, so daß Verarbeitungsprobleme, wie Verschlammung in den Entwicklungsgeräten, nicht auftreten.

Überraschenderweise wurde im Laufe der Untersuchungen gefunden, daß die Lichtempfindlichkeit einer Platte mit aufgesprühter lichtempfindlicher Schicht mit einem Schichtgewicht der aufgesprühten Schicht zwischen 0,1 und 0,8 g/m² sich nicht von der Lichtempfindlichkeit der Platte ohne aufgesprühte Deckschicht unterscheidet, dafür aber alle Vorzüge der Platten mit rauher Oberfläche aufweist.

Das Schichtgewicht der aufgesprühten lichtempfindlichen Schicht kann zwischen etwa 0,05 und 1 g/m² liegen, bevorzugt werden Schichtgewichte von 0,1 bis 0,8 g/m². Die Wirksamkeit der aufgesprühten Schicht liegt weniger an der Wahl eines bestimmten Schichtgewichts, vielmehr ist dafür die Morphologie der Oberfläche nach dem Trocknen verantwortlich. Von ausschlaggebender Bedeutung ist die Wahl des verwendeten Lösemittels bzw. Lösemittelgemisches und des Feststoffgehalts der Beschichtungslösung. Es kommen dafür z. B. in Betracht: Methanol, Ethanol, Butanon, Methylisobutylketon, Tetrahydrofuran, 2-Methoxy-ethanol, 2-Methoxy-ethylacetat, 2-Ethoxy-ethanol, 2-Ethoxy-ethylacetat, Diacetonalkohol, Cyclohexanon, Methoxypropanol, Dimethoxyethan, Pyrrolidon, N-Methyl-pyrrolidon, Butyrolacton, Butylacetat und Ethylacetat. Die verwendeten Lösemittel oder Gemische richten sich nach der Löslichkeit der verwendeten Schichtbestandteile und nach dem resultierenden Verdunstungsverhalten sowie nach dem gewünschten Anlöseverhalten der auf die Oberfläche auftreffenden Flüssigkeitströpfchen. Besonders vorteilhaft hat sich eine resultierende Verdunstungszahl des Lösemittels bzw. Lösemittelgemisches zwischen 20 und 100 erwiesen (Diethylether = 1). Der Feststoffgehalt der Sprühlösung liegt im allgemeinen zwischen 5 und 50 Gew.-%. Die aufgesprühten Teilchen liegen nach dem Trocknen, das durch bekannte Techniken wie Blasen mit heißer Luft oder Bestrahlen mit IR-Strahlern ausgeführt werden kann, in statistisch verteilter Form auf der Oberfläche der lichtempfindlichen Schicht vor. Die Anzahl beträgt im Mittel etwa 2 bis 1000 Teilchen/mm². Ihre Höhe liegt zwischen 0,1 und 10, vorzugsweise zwischen 0,1 und 5 $\mu$m; der Durchmesser der Tröpfchen oder der durch Verlaufen entstandenen Aggregate kann etwa 1 bis 400 $\mu$m betragen.

Die erfindungsgemäßen Aufzeichnungsmaterialien werden vorzugsweise für die Herstellung von Flachdruckplatten verwendet. Sie sind jedoch grundsätzlich für alle Anwendungen geeignet, bei denen eine licht- bzw. strahlungsempfindliche Schicht im Vakuumkontakt unter einer Vorlage belichtet wird, bei der es auf hohe Auflösung und genaue Wiedergabe der Bildelemente ankommt. So lassen sich z. B. erfindungsgemäß hergestellte Aufzeichnungsmaterialien zu Farbprüffolien, Mehrmetalldruckplatten und Siebdruckschablonen verarbeiten.

Als Schichtträger für Flachdruckplatten, auf denen die lichtempfindlichen Schichten aufgebracht sind, wird im allgemeinen Aluminium verwendet, das mechanisch, chemisch oder elektrochemisch aufgerauht ist. Es kann ferner in bekannter Weise in Schwefel- oder Phosphorsäure anodisch oxidiert werden, so daß ein Oxidgewicht zwischen 0,5 und 10 g/m² erhalten wird.

Nach der Aufrauhung und vor dem Anodisieren kann noch alkalisch oder sauer zwischengebeizt werden. Außerdem kann der Träger nach dem Anodisieren einer Vorbehandlung, z. B. mit Silikaten oder Polyvinylphosphonsäure, unterworfen werden, um die Eigenschaften der Oberfläche, insbesondere die Hydrophilie, zu verbessern. Es können auch andere Trägermaterialien wie Stahl, Kupfer, Chrom, Mehrmetallplatten, Kunststoff oder Papier, gegebenenfalls mit einer entsprechenden Vorbehandlung, verwendet werden.

Als lichtempfindliche Schichten kommen alle in der Reproduktionstechnik üblichen positiv oder negativ arbeitenden Schichten in Betracht. Als positiv arbeitende Schichten werden insbesondere solche auf der Basis von 1,2-Chinondiaziden oder von säurespaltbaren Verbindungen eingesetzt. Die letzteren enthalten eine Verbindung, die unter aktinischer Bestrahlung eine starke Säure bildet, z. B. organische Halogenverbindungen, wie trichlormethylsubstituierte s-Triazine oder andere Trichlormethylheterocyclen, Diazoniumsalze starker Säuren oder 1,2-Naphthochinon-2-diazid-4-sulfonylchlorid, und eine Verbindung, die mindestens eine säurespaltbare C-O-C-Gruppe enthält.

Als säurespaltbare Verbindungen sind insbesondere Polyacetale, Orthocarbonsäureester, Enolether und N-Acyliminocarbonate geeignet.

Negativ arbeitende Schichten können z. B. solche auf der Basis von 1,4-Chinondiaziden, Diazoniumsalz-Polykondensationsprodukten, lichtvernetzbaren Polymeren wie Polyvinylcinnamat, Aziden und photopolymerisierbaren Gemischen aus polymerisierbaren (Meth)acrylestern und Photoinitiatoren sein.

In der Regel enthalten die lichtempfindlichen Schichten wasserunlösliche polymere Bindemittel. Wenn sie mit den bevorzugten wäßrig-alkalischen Entwicklerlösungen verarbeitet werden sollen, sollten die Bindemittel in wäßrigen Alkalien löslich oder mindestens quellbar sein. Beispiele für geeignete Bindemittel sind Novolake und Carboxylgruppen enthaltende Mischpolymerisate.

Die Beschichtung des Trägermaterials mit der ersten lichtempfindlichen Schicht erfolgt in bekannter Weise durch Aufschleudern, Tauchen, mittels Walzen, Schlitzdüsen, Rakeln oder durch Gießer-Antrag. Das Schichtgewicht einer so aufgebrachten Schicht liegt zwischen 0,2 und 10, vorzugsweise bei 0,5 bis 8 g/m². Die Schicht wird bei 110 bis 130 °C vollständig getrocknet.

Die rauhe Schicht wird dann vorzugsweise durch elektrostatisches Sprühen aufgebracht, zusätzlich kann mit Druckluft geblasen werden. Das elektrostatische Verfahren hat den Vorteil einer guten Ausbeute, weil durch die zwischen Platte (Kathode) und Sprühkopf (Anode) angelegte Hochspannung ein starkes elektrisches Feld entsteht, so daß weitgehend alle Tröpfchen von der Scheibe auf die Platte gelangen.

Die Lösung kann leicht so eingestellt werden, daß die beim Zerstäuben gebildeten feinen Tröpfchen, während sie von der Zerstäuberdüse im elektrischen Feld zur lichtempfindlichen Schicht wandern, einen Teil ihres Lösemittelgehalts durch Verdunstung verlieren und dabei in einen viskoseren, nicht mehr verlauffähigen Zustand übergehen. Beim Auftreffen auf der lichtempfindlichen Oberfläche bleiben diese Tröpfchen, ohne wesentlich zu verlaufen, als diskrete Partikel sitzen und verbinden sich über den noch vorhandenen Rest an Lösemittel mit der darunterliegenden lichtempfindlichen Schicht und besitzen dadurch eine hervorragende Haftung.

Die Partikelgröße läßt sich einfach einstellen durch geeignete Verdünnung der Ausgangslösung. Die Zahl der Partikel wird durch die abgesprühte Menge bestimmt. Die Anzahl der Teilchen pro Flächeneinheit ergibt sich dann aus der in der Zeiteinheit an der Sprühdose vorbeigeführten Fläche.

Die getrockneten Aufzeichnungsmaterialien werden in üblicher Weise im Vakuumkopierrahmen im Kontakt mit einer Transparentvorlage belichtet und dann entwickelt. Bei negativ arbeitenden Schichten werden die unbelichteten, bei positiv arbeitenden die belichteten Schichtbereiche mit der Entwicklerlösung ausgewaschen. Die Zusammensetzung der Entwicklerlösung richtet sich nach der Natur der lichtempfindlichen Schicht. Wäßrige Lösungen, insbesondere wäßrig-alkalische Lösungen oder wäßrige Netzmittellösungen werden bevorzugt. Nach der Entwicklung verbleibt an den Bildstellen die aufgesprühte rauhe Deckschicht auf der lichtempfindlichen Schicht. Bei der Anwendung als Flachdruckform weisen die Bildstellen mit rauher Oberfläche in der Regel eine besonders gute Farbannahme auf. Im übrigen wird das erfindungsgemäße Aufzeichnungsmaterial in völlig gleicher Weise verarbeitet wie ein übliches Material gleicher Zusammensetzung, das keine rauhe Deckschicht trägt.

Die Vorteile des erfindungsgemäßen Verfahrens sind vor allem:

1. Es wird kein eigener Verfahrensschritt zur Herstellung der Partikel wie z. B. Mahlen, Klassieren, Dispergieren benötigt. Änderungen lassen sich schnell und problemlos bewerkstelligen.

2. Durch die Verwendung der gleichen Schichtzusammensetzung bei der aufgesprühten Schicht wie bei der eigentlichen lichtempfindlichen Schicht treten keine Probleme auf, die durch die unterschiedliche Löslichkeit von Deckschicht und darunterliegender lichtempfindlicher Schicht im Entwickler bedingt sind.

3. Die Haftung der aufgesprühten lichtempfindlichen Partikel auf der darunterliegenden lichtempfindlichen Schicht ist sehr gut.

4. Die Unterstrahlung wird verhindert.

5. Die Evakuierzeit im Belichtungsrahmen ist deutlich verkürzt.

6. Die Belichtungszeit wird durch die aufgesprühte Schicht nicht verlängert.

7. Der Entwickler wird nicht durch unlösliche Fremdsubstanzen verunreinigt und nicht schneller verbraucht als bei einer Platte ohne aufgesprühte Deckschicht.

Die folgenden Beispiele erläutern bevorzugte Ausführungsformen der Erfindung. Gewichtsteile (Gt) und Volumenteile (Vt) stehen im Verhältnis von g zu cm$^3$. Prozentzahlen und Mengenverhältnisse sind, wenn nichts anderes angegeben ist, in Gewichtseinheiten zu verstehen.

Beispiel 1

Auf ein elektrolytisch aufgerauhtes und anodisiertes Aluminiumband wurde mittels einer Breitschlitzdüse die folgende Lösung aufgebracht:

| | |
|---|---|
| 6,6 | Gt Kresol-Formaldehyd-Novolak mit dem Erweichungsbereich 105 - 120 °C nach DIN 53 181, |
| 1,1 | Gt des 4-(2-Phenyl-prop-2-yl)-phenylesters der 1,2-Naphthochinon-2-diazid-4-sulfonsäure, |
| 0,6 | Gt 2,2'-Bis-(1,2-Naphthochinon-2-diazid-5-sulfonyloxy)-dinaphthyl-(1,1')-methan, |
| 0,24 | Gt 1,2-Naphthochinon-2-diazid-4-sulfonylchlorid und |
| 0,08 | Gt Kristallviolett in |
| 91,38 | Gt eines Lösemittelgemisches aus 4 Vt 2-Methoxy-ethanol, 5 Vt Tetrahydrofuran und 1 Vt Butylacetat. |

Das beschichtete Band wurde im Trockenkanal bei Temperaturen bis 120 °C getrocknet.

Es wurde dann in Formate geschnitten, von denen ein Teil (Platte A) zurückbehalten und der Rest durch eine elektrostatische Beschichtungseinrichtung gefahren wurde. Die Antragselektrode bestand aus einem Fliehkraftzerstäuber (Glockenzerstäuber), der pneumatisch mit Druckluft angetrieben wird. Die erreichbare Umdrehungszahl liegt zwischen 30.000 und 50.000 U/min und ist eine Funktion des angewendeten Drucks. Dieser hatte in der verwendeten Anlage einen Wert von 5 bar. Die angelegte Hochspannung betrug 80 kV, wobei der negative Pol an der Antragselektrode anlag und die zu beschichtende Platte mit der zugehörigen Transporteinrichtung an Erde gelegt war. Es wurde eine Pumpe von 1,8 cm$^3$ Schöpfvolumen mit einer Pumpendrehzahl von 20 U/min benutzt. Der Abstand der Glocke zur Plattenoberfläche betrug 260 mm, die Transportgeschwindigkeit 2,5 m/min.

Es wurde eine Beschichtungslösung eingesetzt, die gleiche Mengen der gleichen Festbestandteile wie die oben angegebene Lösung enthielt, die aber in diesem Fall in 51,72 Gt eines Lösemittelgemisches aus 7 Vt Cyclohexanon, 2 Vt 2-Ethoxy-ethanol und 1 Vt Butylacetat gelöst waren.

Dann wurde 3 Minuten bei 100 °C in einem Umluftofen nachgetrocknet. Das Resultat war eine rauhe Oberfläche aus lichtempfindlichen Partikeln, die sehr gut auf der Unterlage hafteten (Platte B).

Diese Platte wurde mit der entsprechenden Platte ohne Zweitbeschichtung (Platte A) verglichen. Das Schichtgewicht der Platte A betrug 2,34 g/m², das der Platte B 2,79 g/m².

Während die Platte B im Kopierrahmen bereits nach 20 Sekunden Absaugzeit (ohne Vorvakuum) in vollständige Berührung mit der Kopiervorlage gebracht werden konnte, ohne daß nach dem Belichten Unterstrahlungserscheinungen auftraten, gelang es erst nach 60 Sekunden Absaugzeit für das Vorvakuum und weiteren 60 Sekunden für das Hauptvakuum, die entsprechende Vergleichsplatte (Platte A), die keine rauhe Oberfläche aufweist, in innige Berührung mit der Filmvorlage zu bringen.

Wenn man Druckplatten von großem Format verwendet, z. B. 1270 x 1035 mm, und diese mit einer ebenso großen transparenten Kopiervorlage mit 50%iger Rasterfläche (60er Raster) im Kopierrahmen montiert und nach einer gleichen Absaugzeit, z. B. von 20 Sekunden für 0 bis 85 % Vakuum, die hierbei resultierenden Kopien vergleicht, erhält man die folgenden Ergebnisse:

Während die Rasterflächen der Kopiervorlage bei Platte B innerhalb der oben angegebenen Belichtungszeit einwandfrei übertragen wurden, zeigten sich bei der Platte A Unterstrahlungserscheinungen in Form von lokalen Aufhellungen in der Rasterfläche infolge spitzer (kleiner) gewordener Rasterpunkte, manchmal waren auch Rasterpunkte vollkommen verlorengegangen. Die Belichtungszeit, in der das 15-μm-Feld einer handelsüblichen Auflösungs-Testvorlage (Fogra PMS-K) nach der bildmäßigen Belichtung und der Entwicklung mit dem unten angegebenen Entwickler nicht mehr wiedergegeben wird, betrug sowohl bei Platte A als auch bei Platte B 100 Sekunden. Das ist insofern überraschend, weil die Platte B ein höheres Gesamtschichtgewicht besitzt.

Die so hergestellten Druckplatten wurden mit einem Entwickler der folgenden Zusammensetzung entwickelt:

| | |
|---|---|
| 5,3 | Gt Natriummetasilikat x 9 H₂O, |
| 3,4 | Gt Trinatriumphosphat x 12 H₂O, |
| 0,3 | Gt Natriumdihydrogenphosphat (wasserfrei), |
| 91,0 | Gt Wasser. |

Beispiel 2

Mit einer Lösung von

| | |
|---|---|
| 1,50 | Gt des Esters aus 1 mol 2,4-Dihydroxy-3,5-dibrom-benzophenon und 2 mol Naphthochinon-(1,2)-di-azid-(2)-5-sulfonsäure, |
| 5,20 | Gt eines Phenol-Formaldehyd-Novolaks mit 14 % phenolischen OH-Gruppen und einem Erweichungspunkt von 110 - 120 °C nach DIN 53 181, |
| 0,20 | Gt Polyvinylbutyral, |
| 0,17 | Gt Kristallviolett, |
| 0,08 | Gt Sudangelb GGN (C.I. 11 021) und |
| 0,60 | Gt Tris-(β-chlorethyl)-phosphat in |
| 92,25 | Gt eines Lösemittelgemisches aus 40 Vt 2-Methoxy-ethanol und 50 Vt Tetrahydrofuran |

wurde ein durch Stahldrahtbürsten aufgerauhtes Aluminiumband beschichtet und anschließend bei Temperaturen bis 110 °C im Trockenkanal getrocknet.

Das so beschichtete Band wurde dann in Formate geschnitten und durch die in Beispiel 1 angegebene elektrostatische Beschichtungseinrichtung gefahren. Die Sprühlösung enthielt die gleichen Mengen der gleichen nicht flüchtigen Bestandteile wie die oben angegebene Beschichtungslösung, die aber in 92,27 Gt eines Lösemittelgemisches aus 80 Vt 2-Methoxy-ethanol, 10 Vt Cyclohexanon und 10 Vt Ethylacetat gelöst waren. Es wurde eine rauhe Oberfläche aus lichtempfindlichen Partikeln erhalten, die sehr gut auf der Unterlage hafteten. Die Zeit bis zum Erreichen des Vakuums wurde deutlich verkürzt.

Beispiel 3

Eine Lösung aus

| | |
|---|---|
| 25 | Gt des Bis-(5-ethyl-5-butyl-1,3-dioxan-2-yl)-ethers des 2-Ethyl-2-butyl-1,3-propandiols, |
| 71 | Gt Kresol-Formaldehyd-Novolak wie in Beispiel 1, |
| 3,3 | Ct 2-(Acenaphth-5-yl)-4,6-bis-trichlormethyl-s-triazin, |
| 0,7 | Gt Kristallviolett-Base und |
| 900 | Gt 2-Methoxy-ethanol |

wurde auf eine elektrolytisch aufgerauhte und anodisierte Aluminiumfolie aufgebracht und getrocknet.

Das so beschichtete Band wurde dann in Formate geschnitten und durch die in Beispiel 1 angegebene elektrostatische Beschichtungseinrichtung gefahren.

Die Beschichtungslösung enthielt die gleichen Mengen der gleichen Schichtbestandteile wie oben, die aber in 1018 Gt eines Lösemittelgemisches aus 7 Vt 2-Ethoxy-ethyl-acetat, 2 Vt 1,2-Dimethoxyethan und 1 Vt Butyrolacton gelöst waren.

Das Resultat war eine rauhe Oberfläche aus lichtempfindlichen Partikeln, die sehr gut auf der Unterlage hafteten. Von der so hergestellten Druckform konnten Drucke in sehr hoher Auflage hergestellt werden.

Ähnliche Ergebnisse wurden erhalten, wenn statt des angegebenen Orthoesterderivats gleiche Mengen des 2,4-Bis-diphenoxymethoxy-acetophenons oder des Polyacetals aus 1-Ethyl-propionaldehyd und Triethylenglykol eingesetzt wurden.

Beispiel 4

Eine elektrolytisch aufgerauhte und anodisierte Aluminiumplatte wurde 1 Minute in eine 60 °C warme Lösung von 0,3 Gew.-% Polyvinylphosphonsäure in Wasser getaucht, danach abgespült, getrocknet und mit der nachstehenden Lösung beschichtet und getrocknet:

| | |
|---|---|
| 0,7 | Gt des Polykondensationsproduktes aus 1 mol 3-Methoxy-diphenylamin-4-diazoniumsulfat und 1 mol 4,4'-Bis-methoxymethyl-diphenylether, ausgefällt als Mesitylensulfonat, |
| 3,4 | Gt 85%ige Phosphorsäure, |
| 3,0 | Gt eines modifizierten Epoxidharzes, erhalten durch Umsetzen von 50 g eines Epoxidharzes mit einem Molgewicht unterhalb 1000 und 12,8 g Benzoesäure in 2-Methoxy-ethanol in Gegenwart von Benzyltrimethylammoniumhydroxid, |
| 0,44 | Gt feingemahlenes Heliogenblau G (C.I. 74 100), |
| 62,0 | Gt 2-Methoxy-ethanol, |
| 30,6 | Gt Tetrahydrofuran und |
| 8,0 | Gt 2-Methoxy-ethylacetat. |

Das so beschichtete Band wurde dann in Formate geschnitten (Platte C) und durch die in Beispiel 1 angegebene elektrostatische Beschichtungseinrichtung gefahren.

Es wurde eine Beschichtungslösung mit den gleichen Inhaltsstoffen wie oben eingesetzt, die aber in 86,5 Gt eines Lösemittelgemisches aus 64 Vt 2-Ethoxy-ethanol, 3 Vt Methanol und 1 Vt Butylacetat gelöst waren. Dann wurde 3 Minuten bei 100 °C nachgetrocknet. Das Resultat war eine rauhe Oberfläche aus lichtempfindlichen Partikeln, die sehr gut auf der Unterlage hafteten (Platte D).

Diese Platte mit der erfindungsgemäßen rauhen Oberfläche (Platte D) wurde mit der entsprechenden Platte ohne rauhe Oberfläche (Platte C) verglichen. Das Schichtgewicht der Platte C betrug 0,98 g/m², das der Platte D 1,12 g/m².

Während die erfindungsgemäß hergestellte Druckplatte (Platte D) im Kopierrahmen bereits nach 20 Sekunden Absaugzeit (ohne Vorvakuum) in vollständige Berührung mit der Kopiervorlage gebracht werden konnte, ohne daß nach dem Belichten Unterstrahlungserscheinungen auftraten, gelang es mit der entsprechenden Vergleichsplatte (Platte C) erst nach 50 Sekunden Absaugzeit für das Vorvakuum und weiterer 40 Sekunden für das Hauptvakuum, diese Druckplatte in innige Berührung mit der Filmvorlage zu bringen.

Wenn man Druckplatten großen Formats, z. B. 1270 x 1035 mm, verwendet und diese mit einer ebenso großen transparenten Kopiervorlage mit 50%iger Rasterfläche (60er Raster) im Kopierrahmen montiert und nach einer Absaugzeit von 20 Sekunden für 0 bis 85% Vakuum, die hierbei resultierenden Kopien vergleicht, erhält man die folgenden Ergebnisse:

Während die Rasterflächen der Kopiervorlage bei Platte D innerhalb der oben angegebenen Belichtungszeit einwandfrei übertragen wurden, zeigten sich bei der Platte C Unterstrahlungserscheinungen in Form einer gewissen Unruhe in der Rasterfläche der bildmäßig belichteten und entwickelten Platte infolge von voller gewordenen Rasterpunkten.

Die Belichtungszeit, in der die 5. Stufe eines Stufenkeils mit 13 Stufen und Dichteinkrementen von 0,15 nach der bildmäßigen Belichtung und Entwicklung mit dem unten angegebenen Entwickler gedeckt erscheint, betrug sowohl bei Platte C als auch bei Platte D 30 Sekunden. Das ist insofern überraschend, weil ja die Platte D ein höheres Schichtgewicht besitzt.

Beide Platten wurden mit einer Lösung von

2,8 Gt Na$_2$SO$_4$ x 10 H$_2$O,

2,8 Gt MgSO$_4$ x 7 H$_2$O,

0,9 Gt Orthophosphorsäure (85 %),

0,08 Gt phosphoriger Säure und

1,6 Gt nichtionischem Netzmittel in

10,0 Gt Benzylalkohol,

20,0 Gt n-Propanol und

60,0 Gt Wasser

entwickelt.

Beispiel 5

Eine Lösung von

| | |
|---|---|
| 10 | Gt des in Beispiel 4 angegebenen Diazoniumsalz-Kondensationsprodukts, |
| 4 | Gt des Azofarbstoffs aus 2,4-Dinitro-6-chlor-benzoldiazoniumsalz und 2-Methoxy-5-acetyl-amino-N-hydroxyethyl-N-cyanoethyl-anilin, |
| 1 | Gt Metanilgelb (C.I. 13 065) und |
| 2 | Gt Phosphorsäure (85 %) in |
| 970 | Gt 2-Methoxy-ethanol |

wurde auf eine elektrolytisch aufgerauhte und anodisierte Aluminiumfolie mit einer Stärke von 0,15
mm aufgebracht.

Das so beschichtete Band wurde dann in Formate geschnitten und durch die in Beispiel 1 angegebene elektrostatische Beschichtungseinrichtung
gefahren.

Es wurde eine Beschichtungslösung eingesetzt, die die gleichen Inhaltsstoffe wie die erste
Beschichtungslösung enthielt, jedoch gelöst in 42
Gt eines Lösemittelgemisches aus 6 Vt 2-Ethoxy-
ethanol, 3 Vt Methanol und 1 Vt Butylacetat. Danach wurde 3 Minuten bei 100 °C getrocknet. Das
Resultat war eine rauhe Oberfläche aus lichtempfindlichen Partikeln, die sehr gut auf der Unterlage
hafteten.

Beispiel 6

Ein Aluminiumträger, der durch Bürsten mit
einer wäßrigen Schleifmittelsuspension aufgerauht
und dann mit einer wäßrigen Lösung von Polyvinylphosphonsäure behandelt worden war, wurde mit
der folgenden Lösung beschichtet:

| 0,6 | Gt des in Beispiel 4 angegebenen Diazoniumsalz-Kondensationsprodukts, |
| 0,06 | Gt Phosphorsäure (85 %), |
| 1,7 | Gt Polyvinylformal (Molgewicht 30,000, 7% Hydroxygruppen) und |
| 2,7 | Gt einer Dispersion von je 10 % Kupferphthalocyaninpigment (C.I. 74 160) und Polyvinylformal in 2-Methoxy-ethyl-acetat in |
| 95 | Gt 2-Methoxy-ethanol. |

Das so beschichtete Band wurde dann in Formate geschnitten und durch die in Beispiel 1 angegebene elektrostatische Beschichtungseinrichtung
gefahren. Dabei wurde eine Beschichtungslösung
aus den gleichen Bestandteilen wie oben eingesetzt, die aber in 49,2 Gt eines Lösemittelgemisches aus 8 Vt 2-Ethoxy-ethanol und 2 Vt Methanol
gelöst waren. Dann wurde bei 100 °C 3 Minuten
nachgetrocknet.

Die Entwicklung erfolgte mit der folgenden Lösung:

| 5,7 | Gt MgSO₄ x 7 H₂SO₄, |
| 25,5 | Gt n-Propanol, |
| 1,1 | Gt 2-(n-Butoxy)-ethanol, |
| 0,7 | Gt Alkyl-polyethoxy-ethanol, |
| 67,0 | Gt Wasser. |

Es wurde eine rauhe Oberfläche aus lichtempfindlichen Partikeln erhalten, die sehr gut auf der
Unterlage hafteten. Von der so hergestellten Druckform konnten Drucke in sehr hoher Auflage hergestellt werden.

Beispiel 7

Als Schichtträger für Druckplatten wurde elektrochemisch aufgerauhtes und anodisiertes Aluminium mit einer Oxidschicht von 2 g/m² verwendet,
das mit einer wäßrigen Lösung von Polyvinylphosphonsäure vorbehandelt worden war.

Es wurde eine Lösung aus

| 2 | Gt eines teilweise mit einem Alkanol veresterten Styrol-Maleinsäureanhydrid-Mischpolymerisats mit einem mittleren Molekulargewicht von 20.000 und einer Säurezahl um 200, |
| 2 | Gt einer 50%igen Lösung eines Diu-rethans, erhalten durch Umsetzen von 1 mol Hexamethylendiisocyanat mit 2 mol Glycerindimethacrylat in Butanon, |
| 0,125 | Gt 9-Phenyl-acridin und |
| 0,05 | Gt des in Beispiel 5 angegebenen blauen Farbstoffs in |
| 25 | Gt Butanon und |
| 12 | Gt Butylacetat |

auf den oben beschriebenen Träger mittels Rakel
aufgebracht. Anschließend wurde die Platte 2 Minuten bei 100 °C im Umlufttrockenschrank getrocknet. Es wurde ein Schichtgewicht von 3,7 - 4 g/m²
erhalten.

Die so beschichtete Platte wurde dann durch
die in Beispiel 1 angegebene elektrostatische Beschichtungseinrichtung gefahren. Zur Beschichtung
wurde eine Lösung der gleichen Bestandteile wie
oben, gelöst in 63 Gt eines Lösemittelgemisches
aus 4 Vt 2-Ethoxy-ethanol, 3 Vt 2-Ethoxy-ethylacetat, 2 Vt Butanon und 1 Vt Butylacetat eingesetzt.
Diese Platte wurde 3 Minuten bei 90 °C getrocknet. Es wurde eine rauhe Oberfläche aus lichtempfindlichen Partikeln erhalten, die sehr gut auf der
Unterlage hafteten.

Zur Entwicklung wurde die folgende Lösung
verwendet:

| 3,0 | Gt Natriummetasilikat x 9 H₂O, |
| 0,03 | Gt nichtionogenes Netzmittel (Kokosfettalkohol-Polyoxyethylenether mit ca. 8 Oxyethyleneinheiten), |
| 0,003 | Gt Antischaummittel, |
| 0,02 | Gt Nitrilotriessigsäure und |
| 0,53 | Gt Strontiumchlorid x 6 H₂O in |
| 96,894 | Gt vollensalztem Wasser. |

Von der so hergestellten Druckform konnten Drucke
in sehr hoher Auflage hergestellt werden.

Beispiel 8

Als Schichtträger wurde elektrochemisch aufgerauhtes und anodisiertes Aluminium von 0,3 mm Stärke mit einer Oxidschicht von 2 g/m² verwendet, das mit einer wäßrigen Lösung von Polyvinylphosphonsäure vorbehandelt worden war.

Es wurde eine Lösung gleicher Zusammensetzung wie die erste in Beispiel 7 angegebene Lösung auf den oben beschriebenen Träger mittels Rakel aufgebracht. Anschließend wurde die Platte 2 Minuten bei 100 °C im Umlufttrockenschrank getrocknet. Es wurde ein Schichtgewicht von 3,7 - 4 g/m² erhalten.

Die gleiche Beschichtungslösung wurde dann mit einer Luftsprühvorrichtung unter einem Druck von 2 bar aus einem Abstand von 30 cm zwischen Sprühvorrichtung und vorbeschichteter Druckplatte aufgesprüht. Das Ergebnis war eine rauhe Oberfläche, die derjenigen von Beispiel 7 sehr ähnlich war.

Die Platte wurde mit dem in Beispiel 7 angegebenen Entwickler verarbeitet.

**Ansprüche**

1. Strahlungsempfindliches Aufzeichnungsmaterial mit einem Schichtträger, einer strahlungsempfindlichen Aufzeichnungsschicht und einer durch Versprühen und Trocknen einer Lösung aufgebrachten rauhen Deckschicht, dadurch gekennzeichnet, daß die Deckschicht im wesentlichen die gleiche Zusammensetzung hat wie die Aufzeichnungsschicht.

2. Aufzeichnungsmaterial nach Anspruch 1, dadurch gekennzeichnet, daß das Schichtgewicht der Deckschicht 0,05 bis 1 g/m² beträgt.

3. Aufzeichnungsmaterial nach Anspruch 1, dadurch gekennzeichnet, daß die Deckschicht vorwiegend aus zu diskreten Partikeln getrockneten Flüssigkeitströpfchen besteht.

4. Aufzeichnungsmaterial nach Anspruch 3, dadurch gekennzeichnet, daß die Partikel im Mittel Höhen von 0,1 bis 10 μm haben.

5. Aufzeichnungsmaterial nach Anspruch 3, dadurch gekennzeichnet, daß die Partikel im Mittel Durchmesser von 1 bis 400 μm haben.

6. Aufzeichnungsmaterial nach Anspruch 3, dadurch gekennzeichnet, daß die Deckschicht im Mittel 2 bis 1000 Partikel je mm² enthält.

7. Verfahren zur Herstellung eines strahlungsempfindlichen Aufzeichnungsmaterials mit rauher Oberfläche, bei dem auf eine auf einem Schichtträger befindliche glatte strahlungsempfindliche Aufzeichnungsschicht eine Lösung so aufgesprüht wird, daß auf der glatten Oberfläche diskrete Flüssigkeitströpfchen gebildet werden, von denen mindestens ein Teil zu diskreten Partikeln getrocknet wird, dadurch gekennzeichnet, daß man eine Lösung aufsprüht, die im wesentlichen die gleichen Bestandteile wie die Aufzeichnungsschicht enthält.

8. Verfahren nach Anspruch 7, dadurch gekennzeichnet, daß man die Lösung elektrostatisch versprüht.

9. Verfahren nach Anspruch 7, dadurch gekennzeichnet, daß man ein organisches Lösemittel oder ein Gemisch von organischen Lösemitteln verwendet, das eine Verdunstungszahl zwischen 10 und 100 aufweist.

10. Verfahren nach Anspruch 7, dadurch gekennzeichnet, daß der Feststoffgehalt der Sprühlösung zwischen 5 und 50 Gew.-% liegt.

**Claims**

1. A radiation-sensitive recording material comprising a layer support, a radiation-sensitive recording layer and a rough covering layer applied by spraying on and drying a solution, characterised in that the covering layer has substantially the same composition as the recording layer.

2. The recording material as claimed in claim 1, characterised in that the layer weight of the covering layer is in the range from 0.05 to 1 g/m².

3. The recording material as claimed in claim 1, characterised in that the covering layer predominantly comprises liquid droplets which have dried to form discrete particles.

4. The recording material as claimed in claim 3, characterised in that the particles have average heights in the range from 0.1 to 10 μm.

5. The recording material as claimed in claim 3, characterised in that the particles have average diameters in the range from 1 to 400 μm.

6. The recording material as claimed in claim 3, characterised in that the covering layer comprises, on an average, from 2 to 1,000 particles per mm².

7. A process for the production of a radiation-sensitive recording material having a rough surface, the process comprising spraying a solution on a smooth radiation-sensitive recording layer which is present on a support, in such a manner that discrete liquid droplets are produced on the smooth surface, at least part of which are dried to form discrete particles, characterised in that a solution is sprayed on which contains substantially the same constituents as the recording layer.

8. The process as claimed in claim 7, characterised in that the solution is sprayed by electrostatic means.

9. The process as claimed in claim 7, characterised in that an organic solvent or a mixture of organic solvents is used, which has an evaporation number in the range between 10 and 100.

10. The process as claimed in claim 7, characterised in that the solids content of the spray solution is in the range between 5 and 50 percent by weight.

## Revendications

1. Matériau d'enregistrement photosensible comportant un support de couche, une couche d'enregistrement photosensible et une couche de revêtement rugueuse déposée par pulvérisation et séchage d'une solution, caractérisé en ce que la couche de revêtement présente pratiquement la même constitution que la couche d'enregistrement.

2. Matériau d'enregistrement selon la revendication 1, caractérisé en ce que le poids de la couche de revêtement est 0,05 à 1 g/m².

3. Matériau d'enregistrement selon la revendication 1, caractérisé en ce que la couche de revêtement se compose essentiellement de particules discrètes fournies à partir de gouttes de liquide séchées.

4. Matériau d'enregistrement selon la revendication 3, caractérisé en ce que les particules ont en moyenne des hauteurs de 0,1 à 10 $\mu$m.

5. Matériau d'enregistrement selon la revendication 3, caractérisé en ce que les particules ont en moyenne des diamètres de 1 à 400 $\mu$m.

6. Matériau d'enregistrement selon la revendication 3, caractérisé en ce que la couche de revêtement contient en moyenne de 2 à 1000 particules par mm².

7. Procédé de fabrication d'un matériau d'enregistrement photosensible à surface rugueuse, dans lequel on pulvérise une solution, sur une couche d'enregistrement photosensible lisse portée par un support de couche, de telle sorte qu'il se forme, sur la surface lisse, des gouttelettes de liquide séparées dont une partie au moins donne des particules séparées par séchage, caractérisé en ce que l'on pulvérise une solution qui renferme essentiellement les mêmes constituants que la couche d'enregistrement.

8. Procédé selon la revendication 7, caractérisé en ce que l'on pulvérise la solution par voie électrostatique.

9. Procédé selon la revendication 7, caractérisé en ce que l'on utilise un solvant organique ou un mélange de solvants organiques qui a un indice d'évaporation compris entre 10 et 100.

10. Procédé selon la revendication 7, caractérisé en ce que la teneur en solides de la solution de pulvérisation est comprise entre 5 et 50% en poids.